Europäisches Patentamt

European Patent Office

Office européen des brevets

(11) Publication number: **0 286 057 B1**

# EUROPEAN PATENT SPECIFICATION

(45) Date of publication of patent specification: **13.07.94**   (51) Int. Cl.⁵: **H03K 17/95**

(21) Application number: **88105410.0**

(22) Date of filing: **05.04.88**

(54) **Proximity switch having an oscillation circuit.**

(30) Priority: **03.04.87 JP 83350/87**

(43) Date of publication of application:
**12.10.88 Bulletin 88/41**

(45) Publication of the grant of the patent:
**13.07.94 Bulletin 94/28**

(84) Designated Contracting States:
**AT BE CH DE ES FR GB GR IT LI LU NL SE**

(56) References cited:
**EP-A- 0 035 960**       **WO-A-83/04458**
**DE-A- 2 829 880**       **GB-A- 2 138 613**
**US-A- 3 133 456**       **US-A- 4 056 769**

**Valvo Schaltungssammlung, vol.1, July 1970,
pages 24-25, Valvo GmbH Editor, Hamburg
Germany; "Induktiver Annäherungsschalter"**

(73) Proprietor: **OMRON TATEISI ELECTRONICS
CO.**
**10, Tsuchido-cho**
**Hanazono**
**Ukyo-ku**
**Kyoto 616(JP)**

Proprietor: **HONDA GIKEN KOGYO KABUSHIKI
KAISHA**

**1-1, 2-chome**
**Minami-Aoyama**
**Minato-ku Tokyo(JP)**

(72) Inventor: **Satou., Shigeru**
**673-32, Kamekubo**
**Oimachi**
**Iruma-gun Saitama-ken(JP)**
Inventor: **Yokota, Tosimitu**
**3-10-6, Kasumigasekikita**
**Kawagoe-shi Saitama-ken(JP)**
Inventor: **Ueda, Kenji Omron Tateisi Electron-
ics Co.**
**Patent Dept.**
**20 Igadera**
**Shimo-Kaiinji**
**Nagaokakyo-City Kyoto 617(JP)**
Inventor: **Hosoya Masakatsu Omron Tateisi
Electronics Co.**
**Patent Dept.**
**20 Igadera**
**Shimo-Kaiinji**
**Nagaokakyo-City Kyoto 617(JP)**

EP 0 286 057 B1

Inventor: **Nakai, Hideo Omron Tateisi Electronics Co.**
**Patent Dept.**
**20 Igadera**
**Shimo-Kaiinji**
**Nagaokakyo-City Kyoto 617(JP)**

(74) Representative: **WILHELMS, KILIAN & PARTNER Patentanwälte**
**Eduard-Schmid-Strasse 2**
**D-81541 München (DE)**

**Description**

The present invention is in the field of proximity switches which detect an object in proximity by a change in the amplitude of an oscillation output or a resonance frequency of an oscillation circuit.

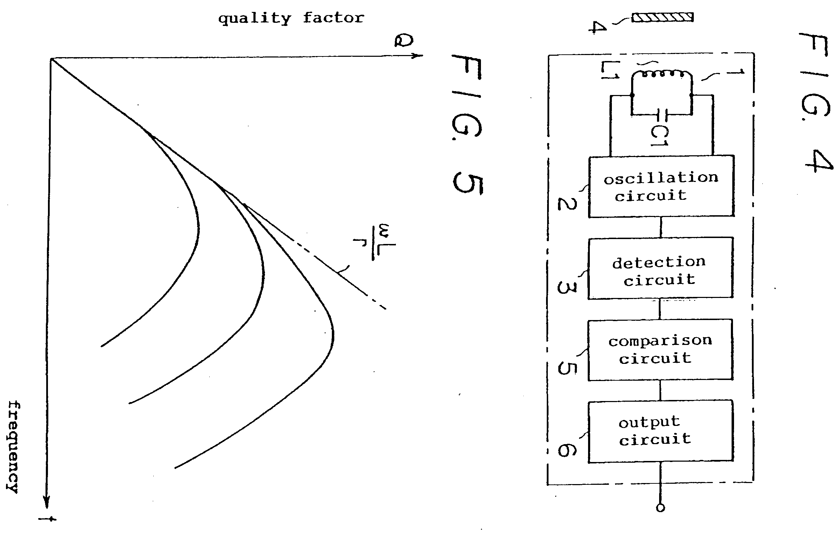

In a typical conventional proximity switch having a resonance circuit whose properties are affected by an object to be detected, a parallel resonance circuit 1 is built by a detection coil $L_1$ and a capacitor $C_1$, for instance as shown in Figure 4, and an oscillation circuit 2 is connected to this parallel resonance circuit 1 so as to produce a high frequency signal which is detected by a detection circuit 3. If a metallic object 4 is brought close to the detection coil $L_1$, the loss in the detection coil $L_1$ is increased and the state of oscillation changes with the result that the amplitude of its output diminishes. The output from the detection circuit 3 is then supplied to a comparison circuit 5 for discriminating it against a prescribed level and an object detection signal is obtained so as to be supplied to an external circuit from an output circuit 6. Thus, an object in proximity can be detected through the detection of the diminishing of the amplitude of the output of the oscillation circuit 2.

In a conventional high frequency oscillation type proximity switch, to the end of making the loss in the detection coil $L_1$ due to the presence of an approaching object in relation with the loss in the coil intrinsic to itself, the oscillation frequency was selected so as to minimize the conductance of the detection coil $L_1$ itself. If the quality factor of the detection coil $L_1$ is Q, its inductance is L, the resonance frequency is f and the value of the parallel capacitor is C, the conductance $g_0$ of the detection coil $L_1$ is then expressed by Equation (1) given below.

$$g_0 = 2\pi fC/Q \qquad (1)$$

$$f = 1/(2\pi\sqrt{LC})$$

Some eddy current is produced in a metallic body if it is brought close to the detection coil of a high frequency oscillation type proximity switch. Therefore, at the same time, the reactance of the detection coil $L_1$ drops and the oscillation frequency rises, thereby reducing the quality factor Q of the detection coil $L_1$. As a result, the conductance of the detection coil $L_1$ increases. The conductance $g_r$ of the detection coil $L_1$ at the resonance point is expressed by Equation (2) given in the following if its variation is expressed by $\Delta g$.

$$g_r = g_0 + \Delta g \qquad (2)$$

In order to detect an object with a high sensitivity, the variation of the conductance $\Delta g/g_0$ is required to be increased and, to this end, the original conductance $g_0$ of the detection coil is desired to be minimized. The quality factor Q of the detection coil $L_1$ is expressed by the ratio of the reactance $\omega L$ at the given frequency to the internal resistance r of the detection coil $L_1$ itself ($\omega L/r$). Therefore, as the frequency rises, the quality factor Q increases but, in reality, due to the distributed capacitance between coil wires and the skin effect, reaches a peak value at a certain frequency characteristic to the detection coil as shown in the graph of Figure 5 which is drawn against frequency. In practice, a frequency in the proximity of this peak frequency is selected as the resonance frequency. As a result, the resonance frequencies of conventional proximity switches using a resonance circuit for high frequency oscillation ranged from several hundred kHz to 1 MHz.

However, in such a conventional high frequency oscillation type proximity switch, the configuration of the metallic objects to be detected was not taken into account when selecting the oscillation frequency. Therefore, the proximity switch demonstrated a same sensitivity irrespective of whether the metallic objects are metallic chips, such as steel chips and aluminum chips, or metallic plates such as steel plates and aluminum plates. As a result, when such a high frequency oscillation type proximity switch is used in conjunction with a machine tool in a manufacturing plant, problems tend to arise because the proximity switch detects not only objects like steel plates and aluminum plates which are desired to be detected but also metal chips which, produced by the operation of the machine tool, may accumulate on the detecting surface of the high frequency oscillation type proximity switch and are not desired to be detected. In particular because cutting oil is used in cutting metallic objects, metal chips tend to build up on the detection surface of the proximity switch and this increases the possibility of the occurrence of the faulty action of the proximity switch.

From VALVO, Schaltungssammlung, Heft 1, Ausgabe 1970 an inductive type proximity switch is known which operates at a frequency of 16.5 kHz. No specific application of this switch is indicated.

DE-A-28 29 880 illustrates the use of a proximity switch enabling to discriminate between an approaching ferrite core on the one hand and arbitrary metal pieces or metal chips on the other hand.

The invention is defined in claim 1.

The range of the resonance frequency from 3 to 15 kHz is preferable if the material of the object to be detected is a steel material, a range of 3 to 8 kHz as defined in claim 2, if it is an aluminum material. The invention is most advantageous in an environment where a machine tool is used and metallic chips tend to accumulate adjacent to the proximity switch.

An accumulation of metallic chips produced from operation of a machine tool is considered to be consisting of a large number of small electroconductive pieces connected together with a certain electric resistivity while a steel or aluminum plate which is to be detected is considered to be consisting of an integral body involving relatively very little resistivity. Therefore, when the oscillation frequency is high, the electromotive force or the induced voltage of the eddy current is high and, therefore, substantially large eddy current will be produced in a metallic plate or in metallic chips. As the frequency becomes lower, the electromotive force of the eddy current becomes lower and substantially large eddy current is produced in the metallic plate but substantially small eddy current is produced in the metallic chips. Therefore, it is possible to distinguish metallic chips from a metallic plate in detecting an object in proximity by lowering the oscillation frequency and evaluating the magnitude of the eddy current which is produced by the presence of the object in proximity of the detection coil.

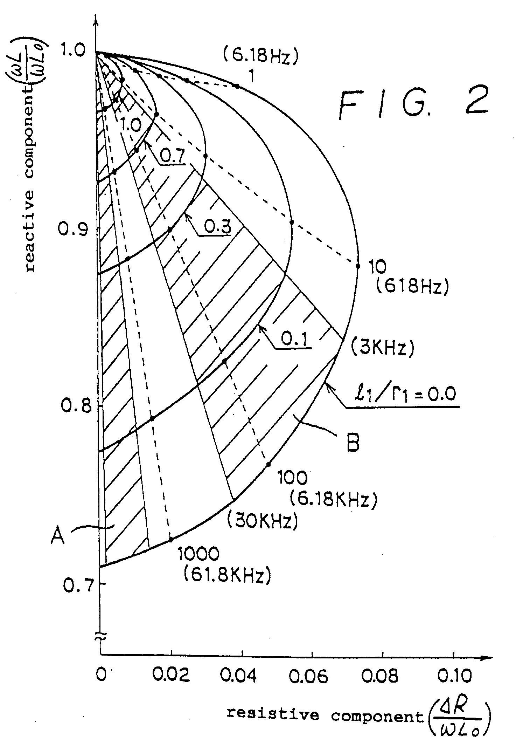

Figure 2 shows the change in the normalized impedance of the detection coil when a nonmagnetic metallic plate is brought close to the detection coil. In this graph, the upper left point corresponds to a state in which there is no metallic object in proximity of the detection coil and, hence, neither the change in the reactance nor the resistive component due to eddy current is produced. In this graph, as a metallic object is brought closer to the detection coil, the normalized distance $l_1/r_1$, defined as a ratio of the distance to the object $l_1$ (infinity to zero) to the radius $r_1$ of the coil $L_1$, changes from infinity to zero. The curves in the graph denote the changes in the reactance and the resistance or, in other words, the loss in the coil against this normalized distance. In this graph, the impedance of the coil itself is set as $Z_0 = R_0 + j\omega L_0$ while the impedance of the coil when a metallic object is brought close to the detection coil is set as $Z = R_0 + \Delta R + j\omega L$, and the vertical axis corresponds to $\omega L/\omega L_0$ while the horizontal axis corresponds to $\Delta R/\omega L_0$. The numerals (1, 10, 100 and 1,000) given in the graph are the values of the normalized frequency F at the corresponding points which are based on Equation (3) given below.

$$F = 2\pi f \mu \sigma r^2 \qquad (3)$$

where     f: frequency of the signal applied to the coil

    $\mu$: permeability of the metallic object

    $\sigma$: electrical conductivity of the metallic object

    r: radius of the coil

This graph applies to non-magnetic materials. When the values of permeability of $1.257 \times 10^{-6}$ (H/m) and electric conductivity of $3.64 \times 10^7$ (1/ohm-m) for aluminum and a coil radius of $7.5 \times 10^{-3}$ (m) are substituted in to the equation, the following relationship holds between the actual frequency and the normalized frequency.

$$f = 61.84 \times F \text{ (Hz)}$$

The values in the brackets in Figure 2 indicate the actual frequencies computed from this formula.

As described above, in conventional high frequency oscillation type proximity switches, since they used frequencies higher than several hundred kHz, their normalized frequencies accordingly ranged in a high range, such as the range indicated by A in Figure 2. In this region, the loss tends to be great even if the electric conductivity of the metallic object is small, and, therefore, small metallic pieces are easily detected. On the other hand, if the normalized frequency is low as represented by the region B in Figure 2, the loss tends to be small if the electric conductivity of the metallic object is small, and, therefore, small metallic pieces are not easily detected. The present invention is based on the proposal to use a low frequency range in which the change in the resistance or, in other words, the loss in the coil upon detection of relatively large metallic objects is great and the change in the resistance or, in other words, the loss in the coil upon detection of relatively small metallic pieces is small. If the frequency is lower than the region B, detection of even a metallic plate may become impossible.

According to the present invention, the oscillation frequency of the high frequency oscillation type proximity switch is reduced to the range of 3 to 15 kHz which is substantially lower than those of

EP 0 286 057 B1

conventional high frequency oscillation type proximity switches. Therefore, planar objects can be detected from the generation of eddy current and the resulting change in the resistance in the coil but small metallic pieces will not generate any significant amount of eddy current and therefore causes very little changes in the resistance of the coil.

Hence, the high frequency oscillation type proximity switch as used according to the present invention is sensitive to planar metallic objects made of aluminum, steel or the like and can detect them but does not detect minute metallic pieces produced by cutting such metallic objects. Therefore, when this high frequency oscillation type proximity switch is used with a machine tool, the proximity switch will not be affected by the metallic chips which are produced as a result of the operation of the machine tool and can drastically improve the reliability of the control system which uses the proximity switch.

Now the present invention is described in the following with reference to the appended drawings, in which:

Figure 1 is a circuit diagram showing the structure of an embodiment of a high frequency oscillation type proximity switch as used according to the present invention;

Figure 2 is a graph showing the frequency curves of the eddy current magnetic flux which is produced in an object to be detected;

Figure 3 is a graph showing changes in the detectable range in relation with the frequency of the detection coil according to the present invention with respect to the threshold value selected from the conductance of aluminum chips which are pressed against the detection surface (C1 and C2) and the threshhold value selected from the conductance of aluminum chips which are simply brought in contact with the detection surface (D1 and D2);

Figure 4 is a block diagram showing a conventional high frequency oscillation type proximity switch; and

Figure 5 is a graph showing the changes in the quality factor (Q) of the coil in relation with the frequency.

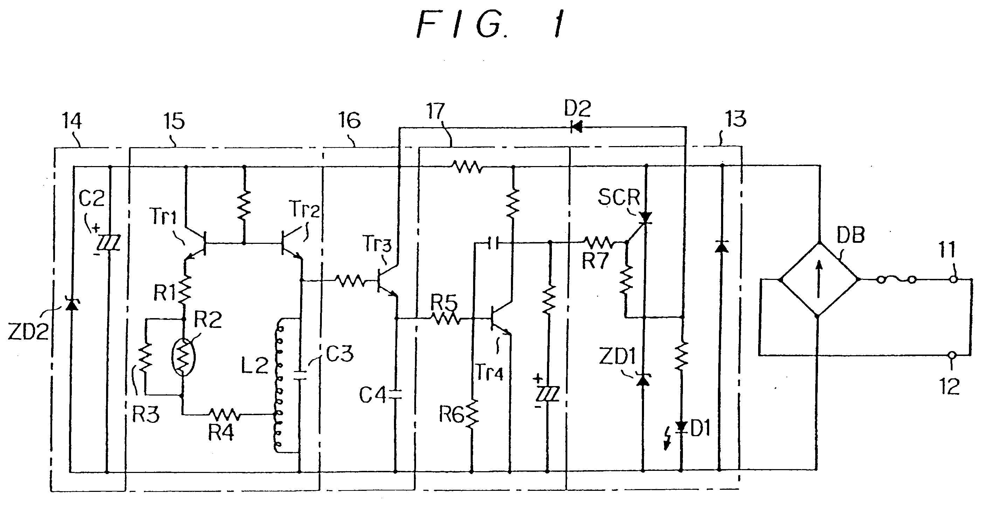

Figure 1 is a diagram showing a circuit structure of an AC 2-line high frequency oscillation type proximity switch as used according to the present invention. In this diagram, a diode bridge DB for full-wave rectification is connected to input terminals 11 and 12. The positive end of the diode bridge DB is connected to a switching circuit 13 having a thyristor SCR and a zener diode ZD1. The zener diode ZD1 supplies a constant voltage to various parts of the circuit when the thyristor SCR is in a conductive state. A light emitting diode D1 is connected in parallel with the zener diode ZD1 for indicating the active state of the circuit. The zener diode ZD1 is further connected to a constant voltage circuit 14 having a zener diode ZD2 and a smoothing capacitor $C_2$, by way of a diode D2. This proximity switch is provided with a Hartley oscillation circuit 15 having a parallel resonance circuit consisting of a detection coil $L_2$ and a capacitor $C_3$. The hot end of the coil $L_2$ of the oscillation circuit 15 is connected to the base of a transistor Tr1 by way of a transistor Tr2 which is connected as a diode and the emitter of this transistor Tr1 is connected to an intermediate tap of the coil $L_2$ by way of a resistor R1, a parallel connection of a thermistor R2 for temperature compensating the osciilation coil $L_2$ and a resistor R3, and a resistor R4. The transistor Tr2 temperature compensates the base-emitter voltage of the transistor Tr1, and its oscillation output is supplied to an integration circuit 16 for its emitter. The collector of a transistor Tr3 in the integration circuit 16 is connected to the power while its emitter is connected to a smoothing capacitor $C_4$ and its integration output is supplied to a comparison circuit 17. The comparison circuit 17 comprises a pair of resistors R5 and R6 which divide the emitter voltage of the transistor Tr3, and a transistor Tr4 which is controlled by the node between the resistors for discriminating the amplitude of the oscillation according to the output from the integration circuit 16. Its output is supplied from the collector of the transistor Tr4 to the gate of the thyristor SCR by way of a resistor R7.

A low oscillation frequency is selected for this embodiment as described earlier. Suppose the detection coil consists of 800 turns of wire which is 0.06 mm in diameter (coil $L_{2a}$) and the value of the capacitor $C_3$ connected in parallel therewith is 0.02 micro F. If the inductance of the detection coil $L_{2a}$ is 2.5 x $10^{-2}$ (H), the oscillation frequency of the oscillation circuit 15 will be 10 kHz. If the detection coil consists of 600 turns of wire which is 0.14 mm in diameter (coil $L_{2b}$) and the inductance of the detection coil $L_{2b}$ is 3.38 x $10^{-2}$ (H) while the value of the capacitor $C_3$ connected in parallel therewith is 0.03 micro F, the oscillation frequency of the oscillation circuit 15 will be 5 kHz. Thus, a frequency range which is substantially lower than those of conventional high frequency oscillation type proximity switches is used.

Tables 1 and 2 given in the following show the changes in the conductance $g_r$ of the detection coil $L_2$ in relation with the distance to objects which consist of a steel plate and an aluminum plate, when the oscillation frequency is varied from 100 Hz to 500 kHz. Table 3 shows changes in the conductance $g_r$ of the detection coil $L_2$ when the distance to the objects to be detected, in this case consisting of aluminum cutting chips as they are and aluminum cutting chips which are compressed by the load of 5 kg, is varied

5

by an increment of 1 mm. The unit of conductance in these tables is given by siemens (S).

## Table 1

| Dist. | 100 Hz | 1 kHz | 2 kHz | 3 kHz | 4 kHz | 5 kHz |
|-------|--------|-------|-------|-------|-------|-------|
| 0 mm  | 18.8   | 1.04  | 0.472 | 0.315 | 0.243 | 0.204 |
| 1 mm  | 22.4   | 1.39  | 0.544 | 0.331 | 0.238 | 0.186 |
| 2 mm  | 23.9   | 1.61  | 0.580 | 0.331 | 0.227 | 0.171 |
| 3 mm  | 24.6   | 1.74  | 0.593 | 0.325 | 0.216 | 0.158 |
| 4 mm  | 25.1   | 1.83  | 0.596 | 0.317 | 0.205 | 0.148 |
| 5 mm  | 25.3   | 1.88  | 0.594 | 0.309 | 0.197 | 0.139 |
| 6 mm  | 25.5   | 1.91  | 0.591 | 0.302 | 0.190 | 0.133 |
| 7 mm  | 25.6   | 1.93  | 0.587 | 0.297 | 0.184 | 0.128 |
| 8 mm  | 25.7   | 1.94  | 0.583 | 0.292 | 0.180 | 0.124 |
| 9 mm  | 25.8   | 1.95  | 0.580 | 0.288 | 0.177 | 0.122 |
| 10 mm | 25.8   | 1.96  | 0.577 | 0.285 | 0.175 | 0.120 |
| inf.  | 25.9   | 1.96  | 0.564 | 0.274 | 0.166 | 0.112 |
| unit  | mS     | mS    | mS    | mS    | mS    | mS    |

| Dist. | 6 kHz | 7 kHz | 8 kHz | 10 kHz | 15 kHz | 20 kHz |
|-------|-------|-------|-------|--------|--------|--------|
| 0 mm  | 0.175 | 0.154 | 0.138 | 0.116  | 8.6    | 6.9    |
| 1 mm  | 0.155 | 0.133 | 0.116 | 0.094  | 6.5    | 5.0    |
| 2 mm  | 0.137 | 0.115 | 0.100 | 0.077  | 5.0    | 3.7    |
| 3 mm  | 0.124 | 0.102 | 0.086 | 0.065  | 4.0    | 2.9    |
| 4 mm  | 0.114 | 0.092 | 0.076 | 0.056  | 3.3    | 2.3    |
| 5 mm  | 0.106 | 0.085 | 0.070 | 0.051  | 2.9    | 2.0    |
| 6 mm  | 0.100 | 0.079 | 0.065 | 0.046  | 2.6    | 1.7    |
| 7 mm  | 0.096 | 0.075 | 0.061 | 0.044  | 2.4    | 1.6    |
| 8 mm  | 0.093 | 0.072 | 0.059 | 0.042  | 2.2    | 1.5    |
| 9 mm  | 0.090 | 0.070 | 0.057 | 0.040  | 2.1    | 1.4    |
| 10 mm | 0.088 | 0.069 | 0.055 | 0.039  | 2.1    | 1.3    |
| inf.  | 0.082 | 0.064 | 0.051 | 0.035  | 1.8    | 1.2    |
| unit  | mS    | mS    | mS    | mS     | $\times 10^{-5}$ S | |

6

| Dist. | 30 kHz | 50 kHz | 100 kHz | 200 kHz | 500 kHz |
|---|---|---|---|---|---|
| 0 mm | 5.1 | 3.5 | 19.47 | 10.63 | 5.04 |
| 1 mm | 3.5 | 2.3 | 12.14 | 6.57 | 3.34 |
| 2 mm | 2.5 | 1.5 | 7.85 | 4.28 | 2.42 |
| 3 mm | 1.8 | 1.1 | 5.38 | 3.00 | 1.92 |
| 4 mm | 1.4 | 0.8 | 3.90 | 2.24 | 1.63 |
| 5 mm | 1.2 | 0.6 | 3.01 | 1.80 | 1.46 |
| 6 mm | 1.0 | 0.5 | 2.45 | 1.52 | 1.36 |
| 7 mm | 0.9 | 0.46 | 2.09 | 1.35 | 1.30 |
| 8 mm | 0.8 | 0.41 | 1.87 | 1.24 | 1.26 |
| 9 mm | 0.8 | 0.38 | 1.72 | 1.17 | 1.23 |
| 10 mm | 0.7 | 0.36 | 1.62 | 1.12 | 1.21 |
| inf. | 0.6 | 0.30 | 1.40 | 1.03 | 1.22 |
| unit | $\times 10^{-5}S$ | | $\times 10^{-6}S$ | | |

## Table 2

| Dist. | 100 Hz | 1 kHz | 2 kHz | 3 kHz | 4 kHz | 5 kHz |
|-------|--------|-------|-------|-------|-------|-------|
| 0 mm | 25.6 | 3.697 | 1.744 | 1.049 | 0.698 | 0.495 |
| 1 mm | 25.7 | 3.135 | 1.279 | 0.713 | 0.454 | 0.313 |
| 2 mm | 25.7 | 2.769 | 1.009 | 0.532 | 0.328 | 0.222 |
| 3 mm | 25.8 | 2.530 | 0.847 | 0.429 | 0.260 | 0.174 |
| 4 mm | 25.8 | 2.370 | 0.750 | 0.370 | 0.221 | 0.147 |
| 5 mm | 25.8 | 2.261 | 0.688 | 0.334 | 0.199 | 0.132 |
| 6 mm | 25.9 | 2.185 | 0.648 | 0.312 | 0.185 | 0.124 |
| 7 mm | 25.9 | 2.131 | 0.622 | 0.298 | 0.177 | 0.119 |
| 8 mm | 25.9 | 2.093 | 0.605 | 0.290 | 0.173 | 0.115 |
| 9 mm | 25.9 | 2.064 | 0.593 | 0.284 | 0.169 | 0.114 |
| 10 mm | 25.9 | 2.043 | 0.585 | 0.281 | 0.168 | 0.113 |
| inf. | 25.9 | 1.964 | 0.564 | 0.274 | 0.166 | 0.112 |
| unit | mS | mS | mS | mS | mS | mS |

| Dist. | 6 kHz | 7 kHz | 8 kHz | 10 kHz | 15 kHz | 20 kHz |
|-------|-------|-------|-------|--------|--------|--------|
| 0 mm | 0.369 | 0.286 | 0.228 | 0.157 | 8.01 | 5.11 |
| 1 mm | 0.229 | 0.175 | 0.138 | 0.0935 | 4.68 | 2.94 |
| 2 mm | 0.161 | 0.122 | 0.096 | 0.0642 | 3.18 | 1.99 |
| 3 mm | 0.125 | 0.094 | 0.074 | 0.0498 | 2.46 | 1.53 |
| 4 mm | 0.106 | 0.080 | 0.0630 | 0.0422 | 2.10 | 1.31 |
| 5 mm | 0.095 | 0.072 | 0.0569 | 0.0384 | 1.93 | 1.20 |
| 6 mm | 0.089 | 0.068 | 0.0536 | 0.0364 | 1.84 | 1.15 |
| 7 mm | 0.086 | 0.065 | 0.0517 | 0.0354 | 1.80 | 1.13 |
| 8 mm | 0.084 | 0.064 | 0.0509 | 0.0348 | 1.79 | 1.13 |
| 9 mm | 0.083 | 0.063 | 0.0504 | 0.0346 | | |
| 10 mm | 0.082 | 0.063 | 0.0502 | 0.0346 | | |
| inf. | 0.082 | 0.064 | 0.0510 | 0.0354 | | |
| unit | mS | mS | mS | mS | $\times 10^{-5}$S | |

EP 0 286 057 B1

| Dist. | 30 kHz | 50 kHz | 100 kHz | 200 kHz | 500 kHz |
|---|---|---|---|---|---|
| 0 mm | 2.84 | 1.43 | 6.10 | 3.31 | 2.47 |
| 1 mm | 1.61 | 0.80 | 3.48 | 2.07 | 1.79 |
| 2 mm | 1.07 | 0.53 | 2.36 | 1.54 | 1.50 |
| 3 mm | 0.82 | 0.40 | 1.84 | 1.28 | 1.35 |
| 4 mm | 0.70 | 0.34 | 1.59 | 1.15 | 1.27 |
| 5 mm | 0.64 | 0.31 | 1.46 | 1.09 | 1.23 |
| 6 mm | 0.62 | 0.30 | 1.40 | 1.05 | 1.20 |
| 7 mm | 0.61 | 0.29 | 1.37 | 1.03 | 1.19 |
| 8 mm | 0.60 | 0.29 | 1.36 | 1.02 | 1.18 |
| 9 mm | | | | | |
| 10 mm | | | | | |
| inf. | 0.6 | 0.30 | 1.40 | 1.03 | 1.22 |
| unit | $x\ 10^{-5}s$ | | $x\ 10^{-6}s$ | | |

## Table 3

| Dist. | 100 Hz | 1 kHz | 2 kHz | 3 kHz | 4 kHz | 5 kHz |
|---|---|---|---|---|---|---|
| 5 kg | 26.0 | 1.988 | 0.577 | 0.285 | 0.175 | 0.121 |
| 0 mm | 25.8 | 1.977 | 0.569 | 0.278 | 0.169 | 0.115 |
| 1 mm | 25.8 | 1.976 | 0.569 | 0.277 | 0.168 | 0.114 |
| unit | mS | mS | mS | mS | mS | mS |

| Dist. | 6 kHz | 7 kHz | 8 kHz | 10 kHz | 15 kHz | 20 kHz |
|---|---|---|---|---|---|---|
| 5 kg | 0.091 | 0.072 | 0.0588 | 0.0430 | 2.57 | 1.87 |
| 0 mm | 0.085 | 0.066 | 0.0533 | 0.0376 | 2.06 | 1.38 |
| 1 mm | 0.084 | 0.065 | 0.052 | 0.0370 | 2.0 | 1.30 |
| unit | mS | mS | mS | mS | $\times 10^{-5}$ S | |

| Dist. | 30 kHz | 50 kHz | 100 kHz | 200 kHz | 500 kHz |
|---|---|---|---|---|---|
| 5 kg | 1.29 | 0.91 | 6.21 | 4.29 | 2.54 |
| 0 mm | 0.83 | 0.49 | 2.96 | 2.12 | 1.66 |
| 1 mm | 0.75 | 0.41 | 2.25 | 1.63 | 1.46 |
| unit | $\times 10^{-5}$ S | | $\times 10^{-6}$ S | | |

In order to detect a metallic body without detecting cutting chips, the conductance of the detection coil when the metallic object to be detected is brought close to the detection coil must be greater than that of the detection coil when cutting chips are pushed against the detecting surface. Since the conductance of the detection coil varies with the distance to the object to be detected, it is possible to express a region which satisfies the above mentioned conditions as a detectable region by taking frequency on the horizontal axis and the distance to the object to be detected on the vertical axis.

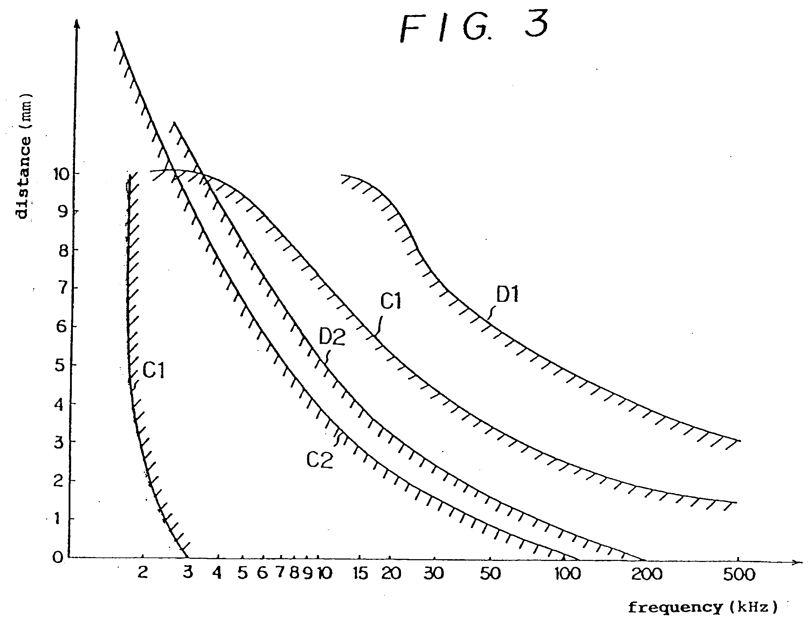

Figure 3 is such a graph which shows a detectable region in relation with frequency. The curve C1 denotes a region in which a steel plate produces a larger change in conductance than aluminum chips which are compressed with a pressure of 5 kg, and curve C2 denotes a detectable region for an aluminum plate under an identical circumstance. Curves D1 and D2 denote regions in which detection of a steel plate and an aluminum plate, respectively, is possible because they produce larger changes in conductance than aluminum chips in a distance zero (or, in other words, when they are accumulated on a detection surface). The curve C1 shows that there is a region in which detection is not possible when the frequency is below 2 kHz because the inductance of the detection coil increases and the loss in the coil increases as a steel plate is brought closer to the detection coil. Therefore, it is necessary to select the oscillation frequency of the oscillation circuit to be higher than 3 kHz. Meanwhile, the upper limit of the frequency is required to be lower than 100 kHz for detecting an aluminum plate. Further, a practical proximity switch must be capable of detecting a steel plate located at a certain distance for instance 8 mm or more and, therefore, the frequency must be lower than 30 kHz in the curve D1. Therefore, a preferable range of the oscillation circuit of a proximity switch is from 3 kHz to 30 kHz and, if a sufficiently large detection range for a steel plate is required, the preferable range should be from 3 kHz to 15 kHz. Further, in order to avoid faulty detection of a steel plate due to the accumulation of aluminum chips on the detection surface, the preferable frequency range is 3 to 8 kHz.

If the frequency range is selected in this way, an aluminum plate or a steel plate at a certain distance can be detected and, yet, aluminum cutting chips and so on in proximity will not be detected. Therefore, the proximity switch according to the present invention can be used as a proximity switch having a selective detection capability which detects an object in proximity depending on its shape.

The constants for the coil given here are only exemplary and the number of winding turns and the inductance of the detection coil should be selected so as to obtain the above described ranges of frequency and inductance.

The present embodiment pertained to a proximity switch which uses a normal Hartley oscillation circuit but it is obvious that similar results can be obtained even when oscillation circuits of other types are used.

## Claims

1. Use of a proximity switch for detecting the presence of an electroconductive object in proximity and comprising an oscillation circuit (15) including an oscillation coil ($L_2$), serving as a resonance element and being provided with a resonance frequency in a range from 3 kHz to 15 kHz, a detecting circuit for detecting a change in oscillation output from the oscillation circuit caused by a change in resistance of the coil (L2), and a determination circuit for evaluating the change detected by the detecting circuit so as to determine if an electroconductive object has come into a certain proximity of the oscillation coil or not, for discriminating in detection between an aggregate of small metallic pieces and relatively large metallic objects present in proximity to the switch.

2. Use of a proximity switch according to claim 1, wherein the resonance frequency is in the range from 3 kHz to 8 kHz.

## Patentansprüche

1. Verwendung eines Näherungsschalters zum Feststellen des Vorhandenseins eines elektrisch leitenden Gegenstands in Nähe und mit einer eine Schwingungsspule ($L_2$) enthaltenden Schwingungsschaltung (15), die als Resonanzelement dient und mit einer Resonanzfrequenz in einem Bereich zwischen 3 kHz und 15 kHz versehen ist, einer Nachweisschaltung zum Feststellen einer Änderung des Schwingungsausgangssignals der Schwingungsschaltung, die durch eine Änderung des Widerstands der Spule ($L_2$) bewirkt ist, und einer Bestimmungsschaltung zum Auswerten der durch die Nachweisschaltung festgestellten Änderung, so daß bestimmt wird, ob ein elektrisch leitender Gegenstand in eine bestimmte Nähe zur Schwingungsspule gelangt ist oder nicht, zur Unterscheidung im Nachweis zwischen einer Ansammlung von kleinen Metallteilen und verhältnismäßig großen metallischen Gegenständen, die in der Nähe des Schalters vorhanden sind.

2. Verwendung eines Näherungsschalters nach Anspruch 1, bei welchem die Resonanzfrequenz im Bereich zwischen 3 kHz und 8 kHz liegt.

## Revendications

1. Utilisation d'un commutateur de proximité pour détecter la présence d'un objet électroconducteur à proximité, comprenant un circuit d'oscillation (15) incluant une bobine d'oscillation ($L_2$) servant d'élément de résonance et présentant une fréquence de résonance dans une plage comprise entre 3 kHz et 15 kHz, un circuit de détection pour détecter une variation de la sortie d'oscillation provenant du circuit d'oscillation provoquée par une variation de la valeur de résistance de la bobine (L2) et un circuit de détermination pour évaluer la variation détectée par le circuit de détection de manière à déterminer si un objet électroconducteur est parvenu à une certaine proximité de la bobine d'oscillation ou non, pour réaliser une discrimination du point de vue de la détection entre un agrégat de petites pièces métalliques et des objets métalliques relativement importants présents à proximité du commutateur.

2. Utilisation d'un commutateur de proximité selon la revendication 1, dans lequel la fréquence de résonance s'inscrit dans une plage qui va de 3 kHz à 8 kHz.

FIG. 1

EP 0 286 057 B1

FIG. 2

F I G. 3

EP 0 286 057 B1

## F I G. 4

## F I G. 5